# EUROPEAN PATENT APPLICATION

(11) **EP 1 130 410 A2**
(43) Date of publication of application: **05.09.2001**
(21) Application number: 01300391.8
(22) Date of filing: 17.01.2001
(51) Int. Cl.: G01R 31/3185

(54) **Scan path constructing program and method, and arithmetic processing system in which said scan paths are integrated**

(30) Priority: 18.01.2000 JP 2000013898
(71) Applicant: Daihen Corporation, Osaka (JP); Roran Co., Osaka (JP)
(72) Inventor: Tanaka, Ryohei, Yodogawa-ku, Osaka (JP); Shigeki, Kenji, Kita-ku, Osaka (JP); Nakao, Toshimitsu, Kita-ku, Osaka (JP)
(74) Representative: Maury, Richard Philip

(57) **Abstract**

In a recording medium storing a scan path constructing program, a program makes a computer read in information about definition of scan paths, to thereby generate a logic of the scan paths at a hardware description language level as a basis of the scan paths constructed on an integrated circuit. This allows a user to easily construct the scan paths for registers and memories on the integrated circuit such as an FPGA based on the logic of the scan paths, thereby making it possible to improve the efficiency of a test for a user-created logic circuit structured on the integrated circuit, and shorten the developing time.

## Description

### BACKGROUND OF THE INVENTION

This invention relates generally to a recording medium storing a program for constructing scan paths which are paths for inputting and outputting data to and from registers or memories on an integrated circuit such as an FPGA (Field Programmable Gate Array) or a PLD (Programmable Logic Device), and relates to a constructing method of the scan paths, and an arithmetic processing system in which said scan paths are integrated. Particularly, this invention relates to an art for improving efficiency and achieving simplification of a board test (actual IC test) for an integrated circuit composed of a CPU, an IP (Intellectual Property) and so forth.

Conventionally, in a field of an integrated circuit such as an ASIC (Application Specific Integrated Circuit) which is a logic circuit for a specific purpose, including the FPGA or PLD, the circuit has become on a large scale, and complicated with sophistication of circuit's functions, so that the test itself has become complicated. The logic circuits composing these integrated circuits are classified into a combinational circuit in which only one output is determined by an input, and a sequential circuit in which output is determined by a past condition and an input function. Among these circuits, in the combinational circuit, there has been a commonly adopted test method wherein a test pattern is automatically created by using D algorithm or random numbers, and said test pattern is used as an input signal to be added to an external terminal of the circuit, thereby checking an output signal which appears in another external terminal. On the other hand, in the sequential circuit such as a flip-flop circuit, it is not easy to arbitrarily set or read out flip-flop values, so that it is difficult to automatically create a test pattern using D-algorithm and so forth. Accordingly, as to the sequential circuit, a scan path method is adopted wherein the flip-flops are linked in a chain-like shape, and designed so as to operate as shift registers, and each of flip-flop values is arbitrarily controlled and observed from an external source by using the shift function in the test (e.g., refer to Japanese patent application unexamined publication No.10-143390).

However, the test in the scan path method according to a conventional manner shown in said Japanese patent application unexamined publication No.10-143390 is implemented by creating a scan path structure for the flip-flops in the circuit at a designing stage by a semi-conductor maker, so that it cannot be applied to a test for an integrated circuit in a method of creating a desired user-created logic circuit at a user's side by arbitrarily writing a logic in a development scene, just as in the case of the FPGA or PLD. Therefore, as to an examination of this kind of circuit, a logic simulation or a timing simulation which uses a PC (Personal Computer) or an EWS (Engineering Work Station) has mainly been carried out. The user-created logic circuit integrated in the FPGA or PLD cannot be efficiently tested, which spends much time for developing the user-created logic circuit on the FPGA or PLD.

### SUMMARY OF THE INVENTION

This invention is made to solve the above-mentioned problems. The first object of the present invention is to provide a recording medium which records a scan path constructing program which allows to easily construct a scan path for registers and memories on an integrated circuit such as an FPGA at a user's side, thereby efficiently carrying out a test for a user-created logic circuit structured on the integrated circuit, and makes it possible to shorten time for developing the user-created logic circuit and to provide a scan path constructing method.

The second object of the present invention is to provide an arithmetic processing system capable of obtaining functions as a CPU core without increasing a scale of a logic circuit on an integrated circuit such as an FPGA.

The third object of the present invention is to provide an arithmetic processing system capable of controlling plural CPU cores in which language specifications are different from each other.

In order to achieve the above-mentioned objects, according to one aspect of the present invention, there is provided a recording medium storing a program for constructing scan paths on an integrated circuit by a computer, which are paths for inputting and outputting data to and from registers and memories on an integrated circuit such as an FPGA: wherein the program makes the computer read in scan path defining information, and generate a logic of scan paths at hardware description language level as a basis for the scan paths to construct on the integrated circuit, based on the scan path defining information.

In the above-mentioned composition, the program makes the computer read in scan path defining information, and generate a logic of scan paths at hardware description language level as a basis for the scan paths to construct on the integrated circuit, based on the scan path defining information. This allows the user to easily construct the scan path for the registers and memories on the integrated circuit such as the FPGA.

Further, the program makes the computer read describing information in a Backus Normal Form about a connecting relation between the generated logic of the scan paths, and logic of a controller for controlling the scan paths, and generate a connection file about the connecting relation at hardware description language level, based on the describing information. This allows to easily connect the scan path circuit and a circuit such as a controller based on the connection file.

According to another aspect of the present invention, there is provided a method of constructing scan paths by a computer, which are paths for inputting and outputting data to and from registers and memories on an integrated circuit such as an FPGA, comprising the steps of: inputting defining information about the scan paths; and generating a logic of scan paths at hardware description language level as a basis for the scan paths to construct on the integrated circuit, based on the scan path defining information.

The above-mentioned method further comprises steps of: inputting describing information in a Backus Normal Form about a connecting relation between the generated logic of the scan paths and logic of a controller for controlling the scan paths; and generating a connection file about the connecting relation at hardware description language level, based on the describing information.

According to a further aspect of the present invention, there is provided an arithmetic processing system including an integrated circuit such as an FPGA, a computer and an interface device transmitting data between the integrated circuit and computer: wherein the integrated circuit is provided with a data path for performing arithmetic processing in a predetermined data width, and a scan path for the data path while the computer is provided with a function for controlling the data path, to thereby transmit data between the computer and data path through the scan path and interface device.

In the above-mentioned composition, the computer transmits control code to the data path which is provided in the integrated circuit side through the scan path and interface device, thereby making it possible to perform arithmetic processing in a predetermined data width in the data path of the integrated circuit side. That is, employing the arithmetic function of the data path of the integrated circuit side and the data path controlling function of the computer side, allows performing the processing which have been performed by the conventional CPU core.

According to further aspect of the present invention, there is provided an arithmetic processing system including plural integrated circuits each having a CPU core, a computer and an interface device transmitting data between the integrated circuits and computer: wherein the arithmetic processing system constructs scan paths for each of CPU cores on plural integrated circuits; and wherein the computer transmits code for controlling each of CPU cores on plural integrated circuits through the scan paths and interface device.

In the above-mentioned composition, the computer transmits the code for controlling each of the CPU cores on the plural integrated circuits through the scan paths and interface device, thereby allowing one computer to control plural CPU cores each having different language specifications by means that the computer transmits control code that is capable of being recognized by the computer.

### BRIEF DESCRIPTION OF THE DRAWINGS

FIG. 1 is a diagrammatic view of an interface system including scan paths constructed by using a program recorded in a recording medium according to one embodiment of the present embodiment.

FIG. 2 is a view showing a detailed structure of the above-mentioned interface system.

FIG. 3 is a view showing a data flow between each of modules in an FPGA in the above-mentioned interface system.

FIG. 4 is a flowchart showing generating processing of each of modules in an ASH based on inputting processing of defining information of the scan path and the input defining information.

FIG. 5 is a view showing defining processing of the scan path.

FIG. 6 is a view showing a data format of the scan path which is automatically created based on the defining information.

FIG. 7 is a view showing logic of the above-mentioned scan path.

FIG. 8 is a view showing the logic of the above-mentioned scan path on a basis of a block of functions.

FIG. 9 is a view showing a connecting method between the above-mentioned scan path and registers in the user-created logic circuit.

FIG. 10 is a view showing a connecting method between the above-mentioned scan path and memories in the user-created logic circuit.

FIG. 11 is a flowchart explaining a method for allowing online-debugging by connecting the above-identified scan path, a select scan module and a main controller.

FIG. 12 is a view showing a connecting terminal between the above-mentioned scan paths, select scan module and main controller.

FIG. 13 is a view showing a connecting method of the interface system including the above-mentioned scan paths.

FIG. 14 is a view showing an arithmetic processing system created by using the above-mentioned scan paths.

FIG. 15 is a view showing an alternative arithmetic processing system created by using the above-mentioned scan paths.

FIG. 16 is a view showing a modified embodiment of the alternative arithmetic processing system created by using the above-mentioned scan paths.

### DETAILED DESCRIPTION OF THE PREFERRED EMBODIMENT OF THE PRESENT INVENTION

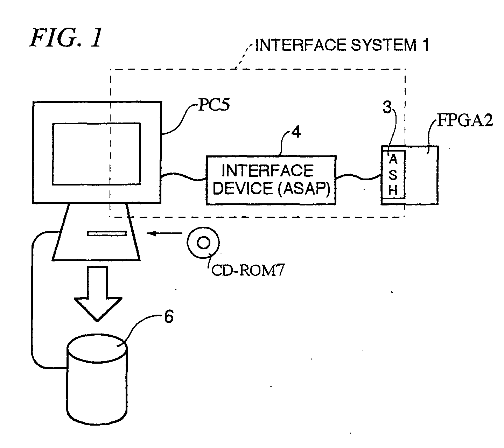

Now, the explanation is given to scan paths which are constructed by employing a program recorded in a recording medium according to the first embodiment of the present invention, and to an interface system which is created by employing said scan paths with reference to the drawings. FIG. 1 shows a diagrammatic view of an interface system 1 which includes scan paths which are constructed by employing the program recorded in the recording medium according to the present embodiment of this invention. The interface system 1 carries out an actual circuit test for a user-created logic circuit on an FPGA (Field Programmable Gate Array) 2 which is a kind of integrated circuit. The interface system 1 comprises an ASH (Adaptive Scan Handler) 3, a PC (Personal Computer) 5 and an interface device (Adaptive Scan Agent Pod, hereinafter referred to as ASAP) 4. The ASH 3 is a debugging module for a user-created logic circuit that is placed in the FPGA 2. The PC 5 issues a command for controlling the ASH 3 and displays a result of executed commands. The ASAP 4 executes transmission and receipt of data between the ASH 3 and the PC 5 according to contents of the command from the PC 5. Further, the PC 5 stores a program (scan path construction program in claims) which generates a logic concerning paths (hereinafter referred to as scan path) for testing the user-created logic circuit on the FPGA 2, and creates a connection file concerning a connecting relation between said logic of the scan paths and a logic of controllers in the ASH 3. The program was installed from a CD-ROM (recording medium) 7. A user activates said program, and creates a source file 6 on the hard disk at a hardware-description language level of the scan path logic and the connection file for the user-created logic circuit. In the present embodiment, since VHDL (VHSIC Hardware Description Language) is employed as a hardware-description language, sources of the scan path logic and connection file which are output in the source file 6 become a VHDL source.

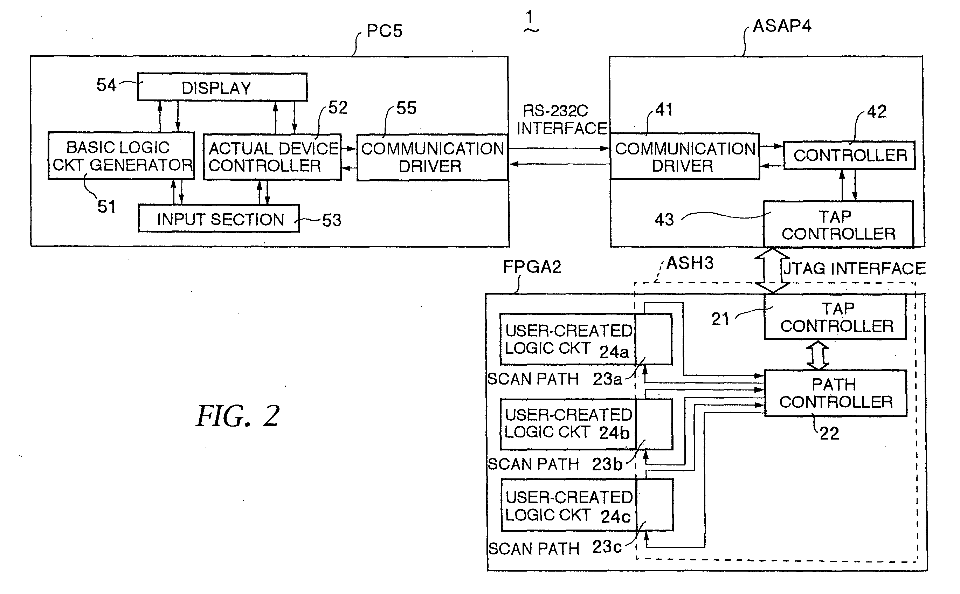

On the basis of the scan path logic at the source level which is output in said source file 6, the scan path circuit is constructed and integrated on the FPGA 2. The following description first explains a configuration of the interface system 1 and data flows after completing the construction and integration of the scan path circuit on the FPGA 2, and then, explains the construction and integration of the scan path circuit on the FPGA 2. FIG. 2 shows a detailed configuration of the interface system 1 in which the scan path circuit is constructed and integrated. The PC 5 comprises a basic logic circuit generator 51, an actual device controller 52, an input unit 53, a display 54 and a communication driver 55. The basic logic circuit generator 51 stores a program for constructing the scan path installed from the CD-ROM 7 shown in FIG. 1. The actual device controller 52 carries out operations such as the issue of a command for controlling the ASH 3 in the actual FPGA 2 test. The input unit 53 inputs data in the basic logic circuit generator 51, and gives instructions to the actual device controller 52. The display 54 displays the result of the executed command that was issued from the actual device controller 52 to the ASH 3. The communication driver 55 communicates with the ASAP 4. Further, the ASAP 4 comprises a communication driver 41, a controller 42 and a TAP controller 43. The communication driver 41 communicates with the PC 5. The controller 42 analyzes broad commands that are transmitted from the PC 5, and issues detail commands to the ASH 3. The TAP controller 43 transmits and receives data to and from the ASH 3 according to the commands from the controller 42. The TAP controller 43 is equipped with a special-purpose terminal for a boundary scan test, which is called as TAP (Test Access Port), and not shown in the figure. The TAP controller 43 transmits and receives signals to and from the ASH 3 by using said terminal. The TAP comprises TDI (Test Data Input), TDO (Test Data Output), TMS (Test Mode Select) and TCK (Test Clock), wherein the TDI inputs data transmitted from the ASH 3, the TDO outputs data to the ASH 3, TMS sets a test-controlling condition, and the TCK inputs a clock for the test.

The FPGA 2 includes said ASH 3 that is the debugging module and includes logic circuits 24a, 24b and 24c which is created by the user. The ASH 3 comprises a TAP controller 21, a path controller 22, and scan paths 23a, 23b and 23c. The TAP controller 21 transmits and receives signals to and from the TAP controller 43 of the ASAP 4. The path controller 22 changes over the path connected with the TAP controller 21 according to the command issued from the actual device controller 52 of the PC 5. The scan paths 23a, 23b and 23c are test paths for capturing and renewing data of memories or registers in the respective user-created logic circuits 24a, 24b and 24c. While data transmission between the PC 5 and the ASAP 4 is carried out by an RS-232C interface, data transmission between the ASAP 4 and the ASH 3 is carried out by a JTAG interface for the boundary scan test.

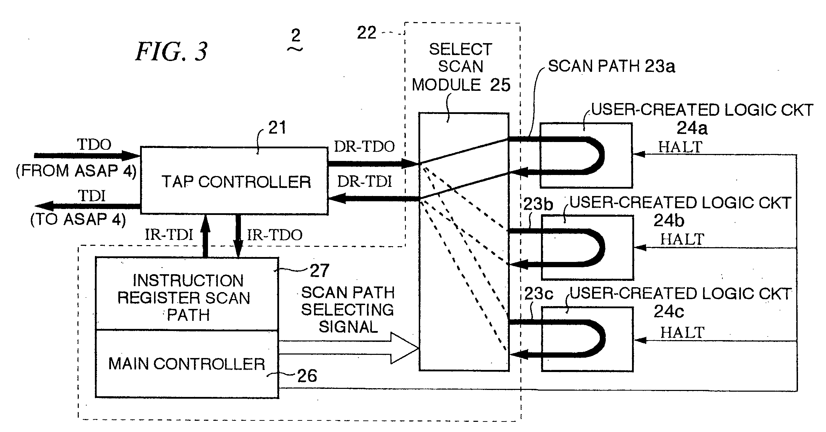

FIG. 3 shows data flows between modules in the FPGA 2. The TAP controller 21 makes the status transit based on a TMS signal (not shown in the figures, signal output from said TMS terminal) which is transmitted from the ASAP 4. Then, according to the status of the TAP controller 21, it is determined whether to access an instruction register scan path 27 which is a scan path for an IR (Instruction Register) in a main controller 26, or to access the scan paths 23a, 23b and 23c for registers or memories of the respective user-created logic circuits 24a, 24b and 24c. When transmitting the command to the IR in the main controller 26, the TAP controller 21 outputs a TDO signal (output signal from TDO terminal) transmitted from the ASAP 4 to the instruction register scan path 27 as an IR-TDO signal. When reading contents of the IR in the main controller 26, the TAP controller 21 transmits an IR-TDI signal output from the instruction register scan path 27 as a TDI signal (input signal to the TDI terminal) to the ASAP 4. When transmitting serial data to registers and memories in each of the user-created logic circuits 24a, 24b and 24c, the TAP controller 21 transmits a TDO signal transmitted from the ASAP 4 as a DR (data register) - TDO signal to the scan paths 23a, 23b and 23c. When capturing contents of the registers or memories of the respective user-created logic circuits 24a, 24b and 24c, the TAP controller 21 transmits DR - TDI signal which is transmitted from the scan paths 23a, 23b and 23c as a TDI signal (input signal to TDI terminal) to the ASAP 4.

In order to select the scan path 23a, 23b or 23c that is accessible from the ASAP 4, SELECT-SCAN-PATH command issued from the PC 5 is transmitted to the instruction register scan path 27 through the ASAP 4 and the TAP controller 21, then the main controller 26 carries out the command. Due to this operation, the main controller 26 transmits a scan path selecting signal to a select scan module 25, thereby selecting the scan path 23a, 23b or 23c that is accessible from the ASAP 4. Besides, there is provided a signal line for HALT signal which gives an instruction whether to transmit data through the scan path 23 to the registers or memories in the user-created logic circuit 24, or to read data through the scan path 23 to the registers or memories in the user-created logic circuit 24.

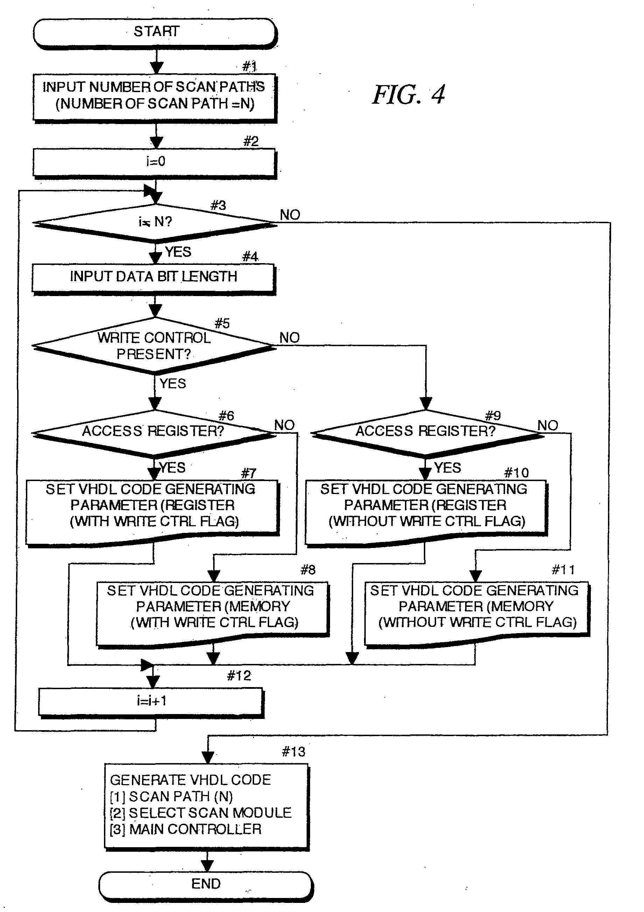

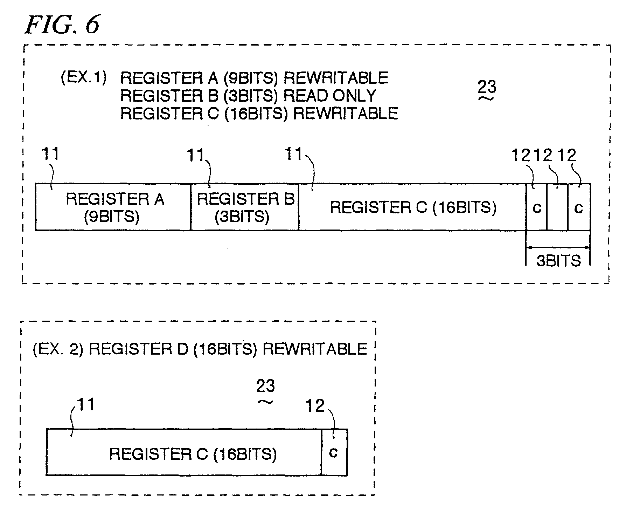

Next, the construction of the circuit of the scan path 23 on the FPGA 2 is explained. The circuit of the scan path 23 is constructed on the basis of the logic at VHDL level of the scan path 23 which is automatically generated by the basic logic circuit generator 51 in the PC 5. The logic generation at VHDL level of the scan path 23 is explained with reference to FIG. 4. Prior to the logic generation of the scan path 23, the user inputs various kinds of defining information about the scan path 23 by using the input unit 53 of the PC 5. That is, the user sets the number of scan paths N to be created (#1), and then inputs the defining information about N scan paths (#2 to #11). Concretely, the user first inputs data bit length of each of the scan path 23 (#4), and then, in order that the data transmitted from the ASAP 4 be written in the registers or memories in a user-created logic circuit 24 through the scan path 23, which means the presence of write-control (YES in #5), and when the scan path 23 is to access the register (YES in #6), the user inputs the defining information about the scan path for the register with a write-control flag (refer to FIG. 6) as an input parameter for generating a VHDL source code of the scan path 23 (#7). Also, when the scan path 23 is to access the memory (NO in #6), the user inputs the defining information about the scan path for the memory with a write-control flag (#8).

On the contrary, in order to read data in the registers or memories in the user-created logic circuit 24 through the scan path 23 without writing data transmitted from the ASAP 4 in the registers or memories in the user-created logic circuit 24 through the scan path 23, which means the absence of write-control (NO in #5), and when the scan path 23 is to access the register (YES in #9), the user inputs the defining information about the scan path for the register without the write-control flag as the input parameter for generating a VHDL source code of the scan path 23 (#10). When the scan path 23 is to access the memory (NO in #9), the user inputs the defining information about the scan path for the memory without the write-control flag (#11). Then, after the user completes inputting the defining information about all of the scan paths 23 (NO in #3), the basic logic circuit generator 51 in the PC 5 generates the VHDL source code about N scan paths, and the select scan module 25 and the main controller 26 corresponding to each of the scan paths 23, based on the input defining information about each of the scan paths 23 (#13).

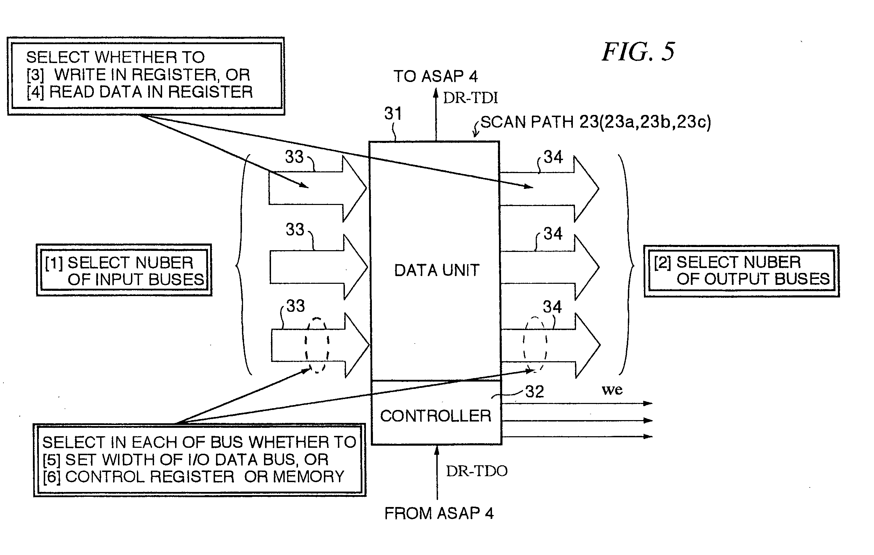

Next, defining processing in each of the scan paths 23 executed in the above-mentioned steps #4 - #11 is explained referring to FIGS. 5 and 6. As shown in FIG. 5, there are six items for defining each of the scan paths 23:
[1] number of input buses 33 (corresponding to the number of registers or memories that can be read by each of the scan paths 23)
[2] number of output buses 34 (corresponding to the number of registers or memories that can be written from each of the scan paths 23)
[3] designation whether or not to write in each of registers (or memories) (write-control is use or unused)
[4] designation whether or not to read data in each of registers (or memories)
[5] width of each of input/output buses 33 and 34
[6] designation whether the scan path accesses registers or memories
Based on the above definition items [1] - [6], the logic between a data unit 31 and a controller 32 which compose the scan path 23 is generated. Besides, the number of lines of we-signal output from the controller 32 is equal to the number of the registers or memories that can be written from each of the scan paths 23.

Next, the explanation is given to data format of the scan path 23 which is automatically generated based on the above definition items from [1] to [6], by the basic logic circuit generator 51 with reference to FIG. 6. As shown in [Example 1] in FIG. 6, when one of the scan paths 23 is to access three registers A, B and C, the scan path 23 comprises three sets of data areas 11 and write-control bits 12 corresponding to the number of bits of each of registers A, B and C. Three write-control bits 12 from the left to the right are bits for storing information of rewriting or not rewriting in registers A, B and C respectively. Each of "c" in the write-control bits 12 shown in FIG. 6 indicate that the registers corresponding to each of the write-control bits 12 can be rewritten. In the case of [Example 1], since the write-control bits in right and left ends are "c", the registers A and C corresponding to each of the write-control bits 12 can be rewritten. Values of each of the write-control bits 12 become "1" in the case of writing in each of registers A and C, and become "0" in the case of only reading data in each of registers A and C. Further, as shown in [Example 2], in the case of accessing one register D only, the scan path 23 comprises one set of the data area 11 and write-control bit 12.

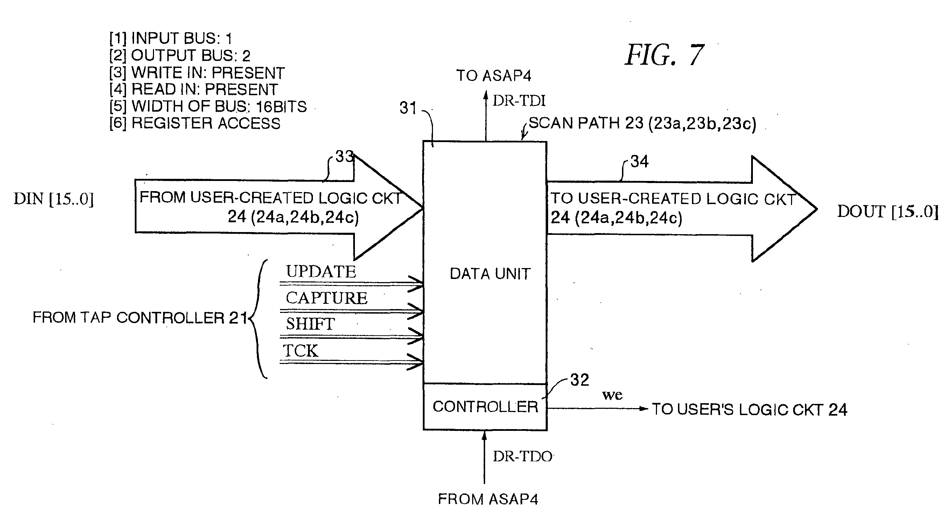

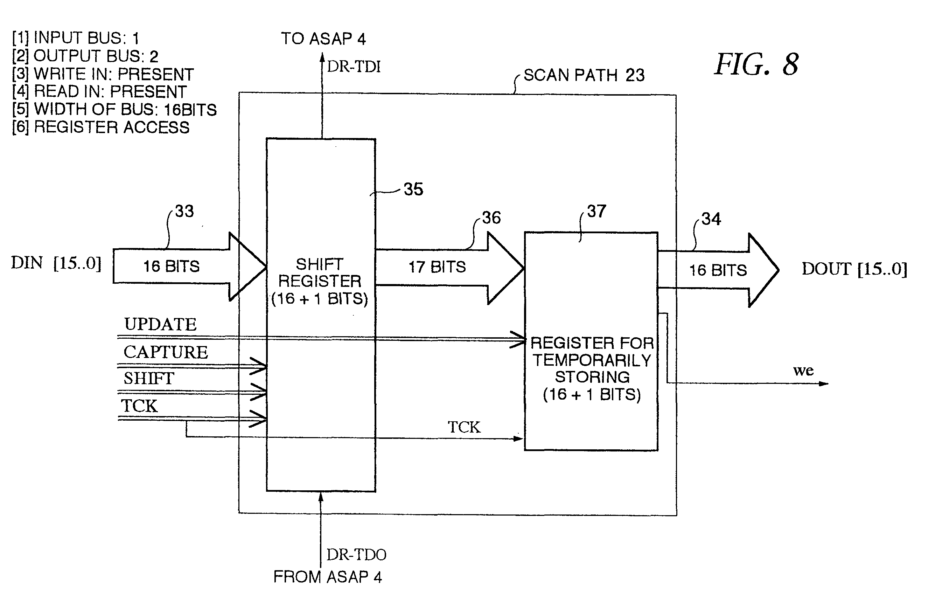

The explanation is nextly given to values of definition items [1] - [6], which are input in creating the scan path 23 shown in the above [Example 2], and to logic of the scan path 23 which is generated based on contents of said definition with reference to FIGS. 7 and 8. As shown in the figures, in the case of creating said scan path 23 in [Example 2], following values are input in each of definition items [1] - [6]:
[1] number of input buses: 1
[2] number of output buses: 1
[3] write-in: present
[4] read-in: present
[5] bus width: 16 bits
[6]scan path accesses: register
Defining the scan path 23 as described in the above-mentioned items [1] - [6], generates one input bus DIN and one output bus DOUT, the bus width of which are 16 bits, as shown in the figures. Further, since the presence of write-in is set in the above [3], and the number of the output bus is set to be 1, one terminal for we-signal is generated in the controller. Furthermore, as shown in the figures, the data unit 31 is provided with terminals for inputting each of signals of UPDATE, CAPTURE, SHIFT and TCK which are control signals from the TAP controller 21. Moreover, as shown in FIG. 8, a shift register 35, a register 37 for temporarily storing and a bus 36 for transmitting data between said registers 35 and 37 are generated in the scan path 23, and an input terminal for DR - TDO which is data to be transmitted from the ASAP 4 to the shift register 35, and an output terminal for DR - TDI which is data to be transmitted from the shift register 35 to the ASAP 4 are generated in up and down positions of the register 35 in the figure.

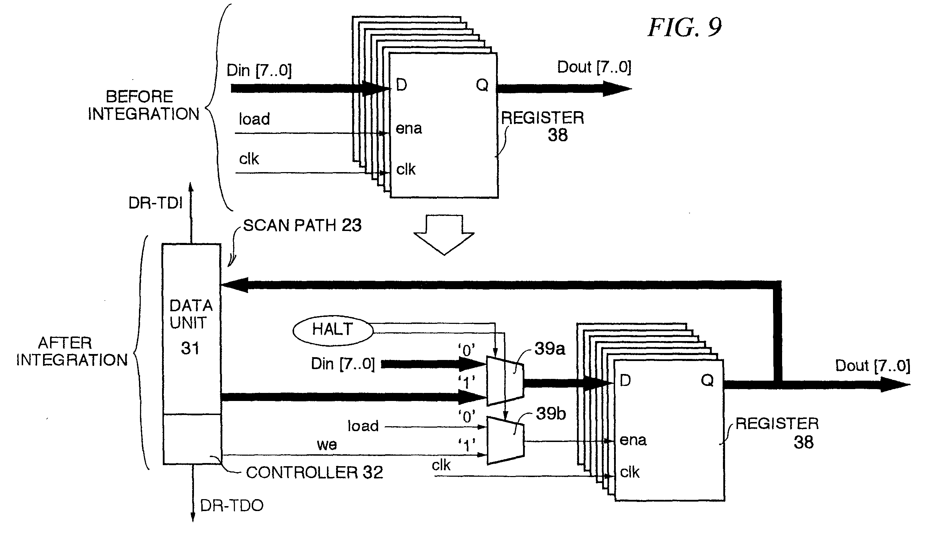

Next, a method for integrating the above-described logic of the scan path 23 in the user-created logic circuit 24 is explained. The integration of the scan path 23 is carried out by a method for connecting the registers or memories in the user-created logic circuit 24 with the scan path 23 through a multiplexer. FIG. 9 shows a connecting method between the scan path 23 and resisters 38 in the user-created logic circuit 24. Din in the figure indicates a bus for inputting data from other registers or memories in the user-created logic circuit 24, and Dout shows a bus for outputting data to other registers or memories in the user-created logic circuit 24. Register 38 has four terminals wherein D-terminal is a terminal for inputting data from Din bus, Q-terminal is a terminal for outputting data to Dout bus, ena-terminal is a terminal for inputting an enable signal, and clk-terminal is a terminal for inputting a clock signal.

In order to connect the scan path 23 for the register which is automatically generated by the basic logic circuit generator 51 according to said definition items [1] - [6], with the register 38, as shown in "After Integration" in FIG. 9, the data unit 31 of the scan path 23 is connected with D-terminal of the register 38 through channel '1' of a multiplexer 39a, and Din bus for inputting data from other registers or memories of the user-created logic circuit 24 is connected with D-terminal of the register 38 through channel '0' of the multiplexer 39a. Further, the controller 32 of the scan path 23 is connected with the ena-terminal of the register 38 through channel '1' of a multiplexer 39b, and a signal line of the enable signal to the register 38 excepting the case of the debugging mode (i.e., normal mode) is connected with ena-terminal of the register 38 through channel '0' of the multiplexer 39b. Furthermore, Dout bus for outputting from Q-terminal is branched, and Q-terminal is connected with the data unit 31 of the scan path 23. When HALT signal is transmitted to the multiplexers 39a and 39b, that is, in the debugging mode, it is set that both channels of the multiplexers 39a and 39b change over into '1'. On the contrary, when HALT signal is not transmitted to the multiplexers 39a and 39b, that is, in the normal mode, it is set that both channels of the multiplexers 39a and 39b change over into '0'.

Owing to the above-described connection between the scan path 23 and register 38, we-signal is transmitted from the controller 32 of the scan path 23 to ena-terminal of the register 38 in the debugging mode, and contents in the data unit 31 of the scan path 23 is written in the register 38 through the multiplexer 39a. At the same time, contents in the register 38 are transmitted from Dout-terminal to the scan path 23 or other memories or registers in the user-created logic circuit 24. On the contrary, in the normal mode, a load-signal is transmitted to ena-terminal of the register 38, and input data from other registers or memories in the user-created logic circuit 24 is loaded in the register 38 through Din bus and the multiplexer 39a. At the same time, the contents in the register 38 are transmitted from Dout-terminal to other memories or registers in the user-created logic circuit 24.

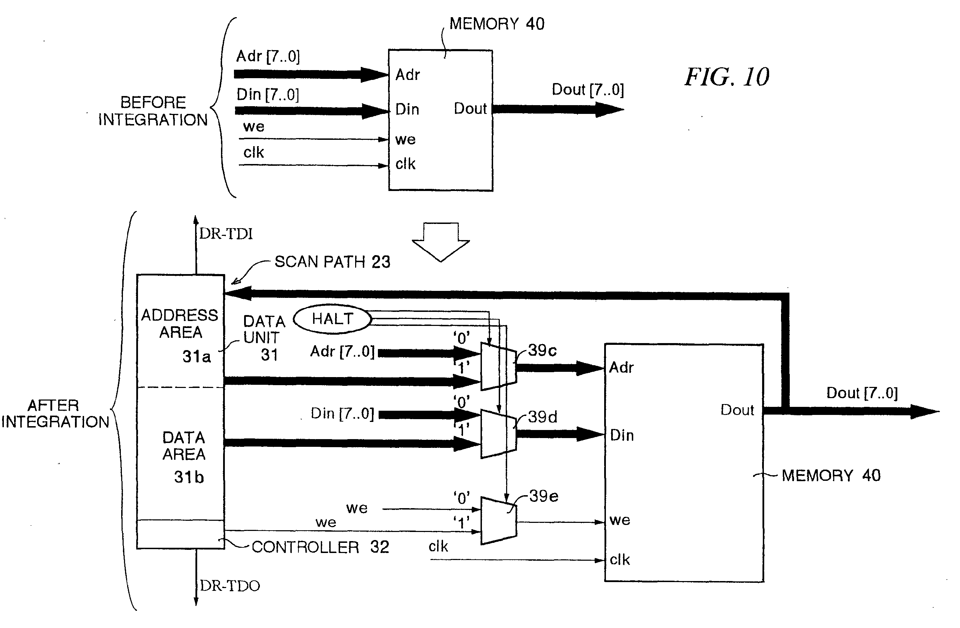

Next, referring to FIG. 10, a method for connecting the scan path 23 with the memories of the user-created logic circuit 24 is explained. A memory 40 has five terminals wherein Adr-terminal is a terminal for inputting addresses of other memories or registers of the user-created logic circuit 24, Din-terminal is a terminal for inputting data from other memories or registers of the user-created logic circuit 24, we-terminal is a terminal for inputting a write-enable signal, clk-terminal is a terminal for inputting a clock signal, and Dout-terminal is a terminal for outputting data to other memories or registers of the user-created logic circuit 24. In order to connect the scan path 23 which is automatically created by the basic logic circuit generator 51 with the memory 40, as shown in "After Integration" in FIG. 10, the bit of an address area 31a in the data unit 31 of the scan path 23 is connected with Adr-terminal of the memory 40 through channel '1' of a multiplexer 39c, and address bus for other memories or registers in the user-created logic circuit 24 is connected with Adr-terminal of the memory 40 through channel '0' of the multiplexer 39c. Further, the bit of a data area 31b in the data unit 31 of the scan path 23 is connected with Din-terminal of the memory 40 through channel '1' of a multiplexer 39d, and the bus for inputting data from other memories or registers in the user-created logic circuit 24 is connected with Din-terminal of the memory 40 through channel '0' of the multiplexer 39d. Furthermore, the controller 32 of the scan path 23 is connected with we-terminal of the memory 40 through channel '1' of a multiplexer 39e, and the signal line of the write-enable signal to the memory 40 in the normal mode is connected with we-terminal of the memory 40 through channel '0' of the multiplexer 39e. Moreover, when a HALT signal is transmitted to the multiplexers 39c, 39d and 39e, that is in the debugging mode, it is set that all channels of the multiplexers 39c, 39d and 39e change over into '1'. On the contrary, when the HALT signal is not transmitted to the multiplexers 39c, 39d and 39e, that is in the normal mode, it is set that all channels of the multiplexers 39c, 39d and 39e change over into '0'.

Owing to the above-described connection between the scan path 23 and memory 40, in the debugging mode, the we-signal is transmitted from the controller 32 of the scan path 23 to we-terminal of the memory 40, and data in the data area 31b of the scan path 23 is written through the multiplexer 39d in the area on the memory 40 corresponding to the address of the address area 31a; at the same time, the same data is transmitted from Dout-terminal of the memory 40 to other resisters or memories in the user-created logic circuit, and to the scan path 23. On the contrary, in normal mode, the we-signal is transmitted to we-terminal of the memory 40, and data transmitted from the data bus is written through the multiplexer 39d into the area on the memory 40 corresponding to the address transmitted from the address bus; at the same time, the same data is transmitted from Dout-terminal of the memory 40 to other resisters or memories in the user-created logic circuit, and to the scan path 23.

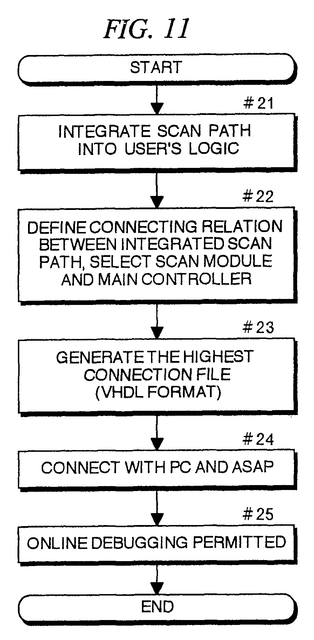

Next, referring to FIG.11, the explanation is given to a method for connecting the scan path 23 integrated in the user-created logic circuit 24 with the select scan module 25 and main controller 26 in VHDL format, which are generated in #13 of FIG. 4, employing the above method. After completing the integration of each of the scan paths 23 in the user-created logic circuit 24 (#21), the user defines a connecting relation between the scan path 23, select scan module 25 and main controller 26 in Backus Normal Form (#22).

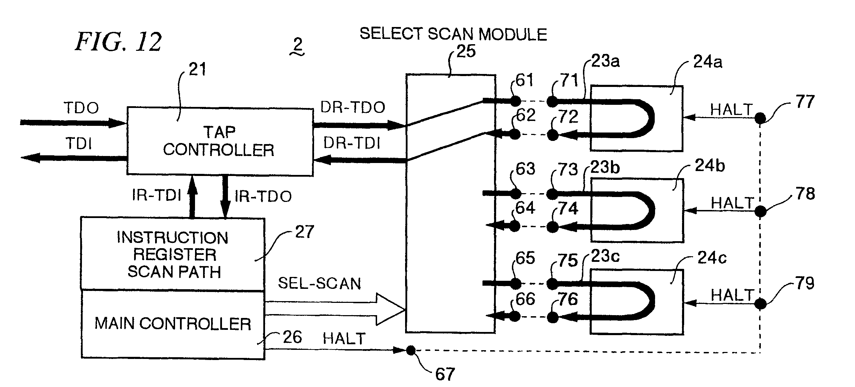

That is, since a procedure for generating VHDL code in #13 of FIG. 4, as shown in FIG. 12 generates input/output terminals 71 - 76 corresponding with the scan paths 23a, 23b and 23c, terminals 77 - 79 for inputting control signals (HALT signal) respectively corresponding with the user-created logic circuits 24a, 24b and 24c, input/output terminals 61 - 66 for the scan paths 23a, 23b and 23c in a select scan module 25 side, and codes in VHDL format corresponding to a terminal 67 for outputting control signal from the main controller 26 to each of the scan paths 23a, 23b and 23c, the user uses these terminal codes, thereby creating sources which describe connecting relations between each of terminals. The basic logic circuit generator 51 in the PC 5 has a compiler of the source described in Backus Normal Form, and if the user inputs the source created in Backus Normal Form, the highest connection file in VHDL format for the connecting relation between the scan paths 23, select scan module 25 and main controller 26 is generated by using said compiler for analyzing contents of the source about the above connecting relation (#23).

Next, employing the method shown in FIGS. 9 and 10, based on the scan path 23 integrated in the user-created logic circuit 24, select scan module 25 and main controller 26 in VHDL format which are generated in #13 of FIG. 4, and the highest connection file in VHDL format which is created in the above #23, the user executes logic synthesis, logic simulation and a locating and wiring design of the ASH 3 including the scan path 23 with the user-created logic circuit 24, and then, implements the user-created logic circuit 24 and the ASH 3 on the FPGA 2 according to the locating and wiring design. After the implementation, the user connects the FPGA 2 with the PC 5 and ASAP 4 (#24), thereby making it possible to issue a control command from the actual device controller 52 to the ASH 3 in the FPGA 2 by using the input unit 53 of the PC 5, and to carry out online debugging (actual circuit test) for the user-created logic circuit 24 (#25).

Next, details of the above online debugging are explained. The actual device controller 52 is equipped with a debugger. When said debugger is activated, a debugger screen is displayed on the display 54 of the PC 5. The user can set break points to the user-created logic circuit 24 such as the CPU core, refer data in the registers 38 or memories 40 on the user-created logic circuit 24, and make the setting for inputting test data to the resisters 38 or memories 40. That is, employing the debugger, the user can arbitrarily control and observe values of the registers 38 or memory 40 in the user-created logic circuit 24 in an FPGA 2 side through the ASAP 4 and the circuit of the scan path 23 from an PC 5 side.

As described above, owing to the interface system 1 which is constructed by using the program recorded in the recording medium according to the present embodiment, since the basic logic circuit generator 51 of the PC 5 generates the scan path 23 in VHDL format according to the scan path defining information defined by the user, the logic of the select scan module 25 and the main controller 26, and the highest connection file in VHDL format about the connecting relations between them, the user, based on the logic in said VHDL level, can easily construct the circuit of the scan path 23 for the resisters 38 or memories 40 in the user-created logic circuit 24 on the FPGA 2, thereby easily integrating the circuit of the scan path 23 in the data transmitting path reaching the registers 38 or memories 40 on the FPGA 2 from the PC 5. This makes it possible to arbitrarily control and observe values of the resisters 38 or memories 40 on the FPGA 2 from the PC 5 side through the circuit of the scan path 23, which allows to efficiently perform the actual circuit test for the user-created logic circuit 24 on the FPGA 2, and shortens time for developing the user-created logic circuit 24.

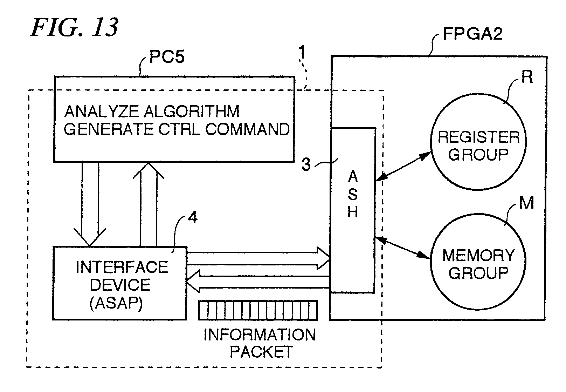

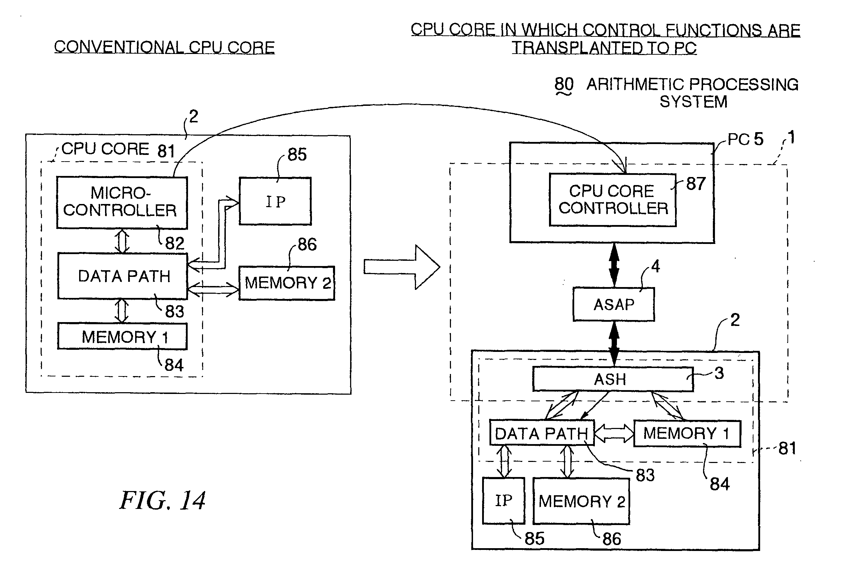

Next, referring to FIGS. 13 and 14, an arithmetic processing system created by using the scan path 23 according to the present embodiment is explained. As shown in FIG. 13, the interface system 1 including the scan path 23 of the present embodiment can generate a control command according to the algorithm created by the user, and transmit said control command to a register group R or memory group M in the FPGA 2 through the ASAP 4 and ASH 3, thereby remotely controlling the CPU core or IP (intellectual property) in the FPGA 2 designed by the user from the PC 5 by using said interface system 1. As shown in FIG. 14, applying this function, makes it possible to achieve an arithmetic processing system 80 wherein control functions (functions included in a conventional micro-controller 82) for data paths (general term of circuits for executing arithmetic processing in predetermined data width such as ALU or an adding machine) 83, which have conventionally been required for composing a CPU core 81 in the FPGA 2, are transplanted in software (CPU core controller 87) on the PC 5. Said arithmetic processing system 80 allows the arithmetic processing through the data paths 83 by transmitting and receiving micro codes in a packet from the CPU controller 87 on the PC 5 through the ASAP 4 and the ASH 3 to the data paths 83 on the FPGA 2. In the conventional CPU core 81, in the case of a complicated algorithm, a logic scale of the micro controller 82 increases at the largest. However, in the arithmetic processing system 80 of the present invention, control functions such as the data paths 83 by the micro-controller 82 are transplanted in the PC 5, which prevents an increase in the logic scale of the CPU core 81 on the FPGA 2, caused by the complication of the algorithm.

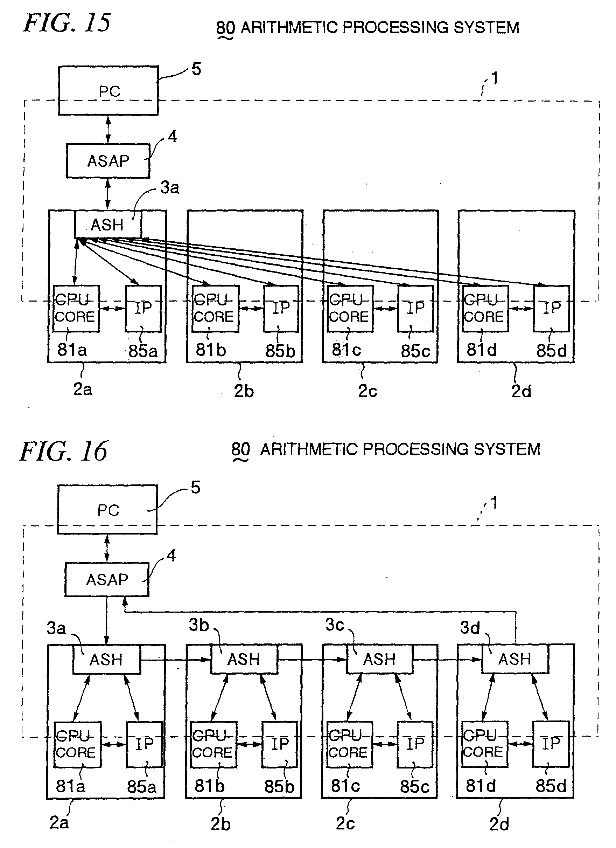

Next, referring to FIGS. 15 and 16, an alternate arithmetic processing system created by using the interface system 1 according to the present embodiment is explained. Said arithmetic processing system 80 has a constitution wherein plural CPU cores 81a - 81d which are respectively located on plural FPGAs 2a - 2d, and have different language specifications, are provided with each of scan paths through which a packet code corresponding with a control command is transmitted from the PC 5 to each of the CPU cores 81a - 81d, thereby controlling the plural CPU cores 81a - 81d through the scan paths. FIG. 15 shows a connecting method in the case that the FPGA 2a is provided with the ASH 3 through which the plural CPU cores 81a - 81d on the FPGAs 2a - 2d are controlled from the PC 5 while FIG. 16 shows a connecting method in the case that each of plural the FPGAs 2a - 2d is respectively provided with the ASHs 3a - 3d connected in a chain-like form, and the CPU cores 81a - 81d in the FPGAs 2a - 2d are controlled from the PC 5 through the ASHs 3a - 3d in the same FPGA. The PC 5 transmits the control command in meta-language form (language in the interpreter-style) to each of the CPU cores 81a - 81d, thereby controlling the plural CPU cores 81a - 81b having different language specifications by using the same software on the PC 5. Also, the PC 5 can directly access memories or registers in IPs 85a - 85d (hereinafter referred to as IP 85) through the scan path, thereby making it possible to control the IP 85 which contains a register interface, or the IP 85 through the memory.

Having described preferred embodiments of the invention with reference to the accompanying drawings, it is to be understood that the invention is not limited to those precise embodiments, and that various changes and modifications may be effected therein by one skilled in the art without departing from the scope or spirit of the invention as defined in the appended claims. For example, although the present invention is applied to the FPGA in the above embodiment, the present invention can also be applied to other integrated circuits such as a PLD (programmable logic device). Also, in the above embodiment, the user creates defining information about connecting relations between the scan paths, select scan module and main controller with each of terminals by a method of describing these relations in Backus Normal Form, but the user can create the defining information about the connecting relation between these components by a method in which the basic logic circuit generator of the PC displays the scan path, select scan module main controller, and each of terminals on the display of the PC, and the user connects these terminals by using a painting program and the like. Further the above embodiment shows a configuration wherein the online debugging of a common user-created logic circuit is carried through scan paths which are constructed in the user-created logic circuit, but the online debugging can also be executed for the CPU core.

## Claims

1. A recording medium storing a program for constructing scan paths on an integrated circuit by a computer, which are paths for inputting and outputting data to and from registers and memories on an integrated circuit such as an FPGA:
wherein the program makes the computer read in scan path defining information, and generate a logic of scan paths at hardware description language level as a basis for the scan paths to construct on the integrated circuit, based on the scan path defining information.

2. The recording medium storing a program for constructing scan paths according to claim 1,
wherein the program makes the computer further read describing information in a Backus Normal Form about a connecting relation between the generated logic of the scan paths, and logic of a controller for controlling the scan paths, and generate a connection file about the connecting relation at hardware description language level, based on the describing information.

3. A method of constructing scan paths by a computer, which are paths for inputting and outputting data to and from registers and memories on an integrated circuit such as an FPGA, comprising the steps of:
inputting defining information about the scan paths; and
generating a logic of scan paths at hardware description language level as a basis for the scan paths to construct on the integrated circuit, based on the scan path defining information.

4. The method of constructing scan paths according to claim 3, comprising steps of:
inputting describing information in a Backus Normal Form about a connecting relation between the generated logic of the scan paths and logic of a controller for controlling the scan paths; and
generating a connection file about the connecting relation at hardware description language level, based on the describing information.

5. An arithmetic processing system including an integrated circuit such as an FPGA, a computer and an interface device transmitting data between the integrated circuit and computer:
wherein the integrated circuit is provided with a data path for performing arithmetic processing in a predetermined data width, and a scan path for the data path while the computer is provided with a function for controlling the data path, to thereby transmit data between the computer and data path through the scan path and interface device.

6. An arithmetic processing system including plural integrated circuits each having a CPU core, a computer and an interface device transmitting data between the integrated circuits and computer:
wherein the arithmetic processing system constructs scan paths for each of CPU cores on plural integrated circuits; and
wherein the computer transmits code for controlling each of CPU cores on plural integrated circuits through the scan paths and interface device.
